# FASCICULE DE BREVET EUROPEEN

(11) **EP 0 528 736 B1**
(45) Date de publication et mention de la délivrance du brevet: **12.07.1995**
(21) Numéro de dépôt: 92402314.6
(22) Date de dépôt: 20.08.1992
(51) Int. Cl.: H01L 21/00

(54) **Dispositif de transfert de plaques, notamment de plaques de silicium**
Vorrichtung zum Transfer von Scheiben, insbesondere Silicon-Scheiben
Plate transfer device, in particular for silicon wafers

(30) Priorité: 20.08.1991 FR 9110447
(43) Date de publication de la demande: 24.02.1993
(73) Titulaire: PHOTOWATT INTERNATIONAL S.A., 92500 Rueil Malmaison (FR)
(72) Inventeur: Dalban-Moreynas, Franck, F-14000 Caen (FR)
(74) Mandataire: Dalsace, Michel

(56) Documents cités:
- PATENT ABSTRACTS OF JAPAN vol. 8, no. 13 (E-222)(1450) 20 Janvier 1984
- TECHNICAL DIGEST - WESTERN ELECTRIC. no. 53, Janvier 1979, NEW YORK US page 3DREXINGER 'Transfer of semiconductor wafers between holders'

## Description

La présente invention concerne un dispositif de transfert de plaques depuis un support d'origine jusqu'à un support de destination, les plaques pouvant ne pas présenter le même espacement lorsqu'elles sont dans les supports d'origine et de destination. Elle s'applique en particulier au transfert de plaques rigides et fragiles telles que des plaques de silicium. Le support d'origine peut être un panier et le support de destination une nacelle susceptible de recevoir le contenu de plusieurs paniers.

Un transfert de plaques d'un support dans un autre peut être effectué manuellement ou de manière mécanique et dans ce cas, le transfert est réalisé plaque par plaque. C'est donc une opération fastidieuse et longue ou alors qui nécessite un matériel important. Lorsque les plaques sont fragiles, il se pose en outre le problème de leur transfert en toute sécurité.

Le transfert de plaques de silicium intervient par exemple au cours de leur traitement. Il arrive que des plaques nécessitant un traitement thermique doivent être transférées d'un support en plastique vers un support en quartz supportant le traitement thermique. Généralement, pour des raisons techniques et pratiques, ces supports n'ont pas la même contenance et n'assurent pas le même écartement entre les plaques. Les supports d'origine sont des paniers en plastique utilisés couramment dans l'industrie électronique. Les supports de destination sont des nacelles en quartz dont le contenu correspond au contenu d'un nombre entier de paniers. Un dispositif de transfert de plaques comme défini dans le préambule de la présente revendication 1 est connu du document JP-A-58-178535. De plus, un poussoir mobile pour transférer des plaques transversalement est décrit dans le document "Technical Digest-Western Electric", Nº 53, Janvier 1979, page 3.

Afin de pallier ces inconvénients, on propose, selon la présente invention, un dispositif permettant le transfert de plaques de façon rapide et sûre, sans risque de les casser ou de les ébrécher, depuis le support d'origine jusqu'au support de destination. Ceci peut être obtenu grâce à un système de guidage des plaques entre les deux supports et grâce à un poussoir assurant le transfert.

L'invention a donc pour objet un dispositif de transfert de plaques transversalement d'un support d'origine vers un support de destination, le support d'origine comprenant des moyens de positionnement permettant de disposer les plaques isolément les unes des autres selon un écartement déterminé et transversalement entre deux faces ouvertes du support d'origine, le support de destination comprenant des moyens de positionnement permettant de disposer les plaques isolément les unes des autres à partir d'une face ouverte selon un écartement identique ou différent de celui du support d'origine, le dispositif comprenant des moyens de guidage des plaques disposés entre l'une des deux faces ouvertes du support d'origine et la face ouverte du support de destination, caractérisé en ce qu'il comprend en outre un poussoir mobile permettant de pousser les plaques hors de leur support d'origine vers leur support de destination, le poussoir traversant dans sa course lesdits moyens de guidage composés de glissières disposées de part et d'autre de l'espace de circulation du poussoir et assurant la continuité du transfert des plaques ainsi que des moyens de déplacement vertical permettant de mettre le support de destination en position pour recevoir successivement le contenu de plusieurs supports d'origine.

Les moyens de guidage du dispositif peuvent amener les plaques au support de destination selon un écartement multiple de celui de ses moyens de positionnement, les moyens de déplacement comprenant en outre des moyens incrémental de déplacement.

Les moyens de guidage peuvent avantageusement comprendre des glissières disposées de part et d'autre de l'espace de circulation du poussoir.

Les moyens de positionnement du support d'origine et/ou du support de destination peuvent comprendre des encoches.

Des mâchoires amovibles peuvent être prévues pour prolonger les moyens de guidage vers le support de destination.

Si les écartements des plaques dans les supports d'origine et de destination sont différents, l'écartement entre les glissières des moyens de guidage peut varier progressivement depuis le support d'origine jusqu'au support de destination.

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue cavalière d'un support de plaques ou panier,
- la figure 2 est une vue cavalière d'un autre support de plaques ou nacelle,
- la figure 3 est une vue cavalière du dispositif de transfert de plaques selon l'invention,
- la figure 4 est une vue de dessus du dispositif de transfert de plaques selon l'invention,
- la figure 5 est une vue de côté du dispositif selon l'invention en cours de fonctionnement.

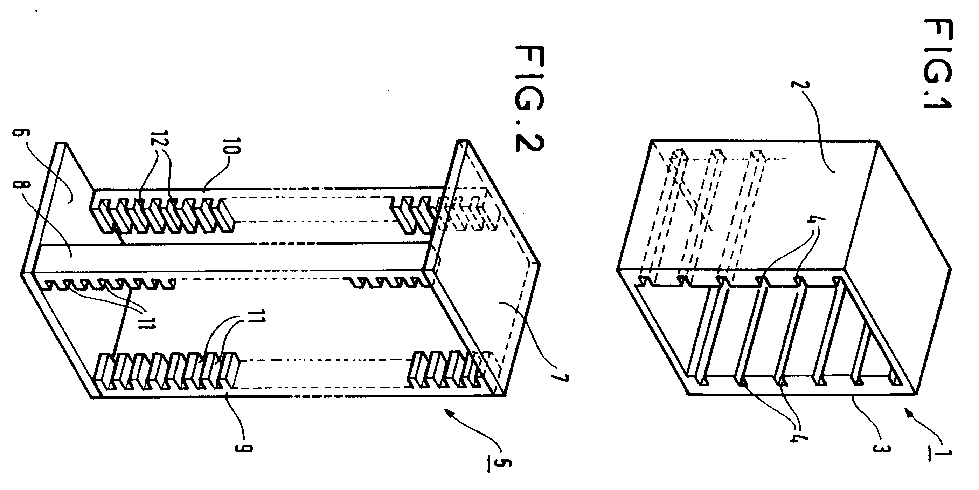

La figure 1 représente un panier en plastique servant de support d'origine à des plaques. Le panier 1 est un parallélépipède rectangle dont deux faces opposées sont ouvertes. Deux autres faces 2 et 3, opposées entre elles, sont munies d'encoches 4 disposées perpendiculairement aux faces ouvertes. Typiquement, un panier peut contenir 25 plaques glissées dans des encoches régulièrement espacées selon un pas de 4,8 mm. Les plaques ont par exemple 0,25 mm d'épaisseur pour 10 cm de côté.

La figure 2 représente une nacelle en quartz servant de support de destination des plaques. La nacelle 5 a une forme de parallélépipède allongé. Elle comprend deux faces pleines opposées : la face inférieure 6 et la face supérieure 7. Les faces 6 et 7 sont reliées entre elles uniquement par trois montants : deux montants avant 8 et 9 disposés selon deux arêtes du parallélogramme et un montant arrière 10 disposé au milieu de la face arrière du parallélogramme. Les montants avant possèdent des encoches 11 régulièrement espacées et disposées perpendiculairement à la face avant et parallèlement aux faces inférieure et supérieure. Le montant arrière 10 possède des encoches 12 régulièrement espacées et correspondant aux encoches 11. Les encoches 12 sont tournées vers l'intérieur du parallélogramme. Grâce aux encoches 11 et 12, la nacelle peut recevoir un certain nombre de plaques disposées parallèlement aux faces inférieure et supérieure et régulièrement espacées.

Typiquement, une nacelle peut contenir 200 plaques glissées dans des encoches espacées selon un pas de 2 mm. Une nacelle peut donc recevoir le contenu de 8 paniers.

Dans le panier aussi bien que dans la nacelle, les plaques sont disposées isolément les unes des autres. Les plaques se placent transversalement entre les faces ouvertes du panier et peuvent dépasser des deux côtés de ces faces. Dans la nacelle, les plaques sont retenues par le montant arrière mais peuvent déborder largement par la face avant de la nacelle.

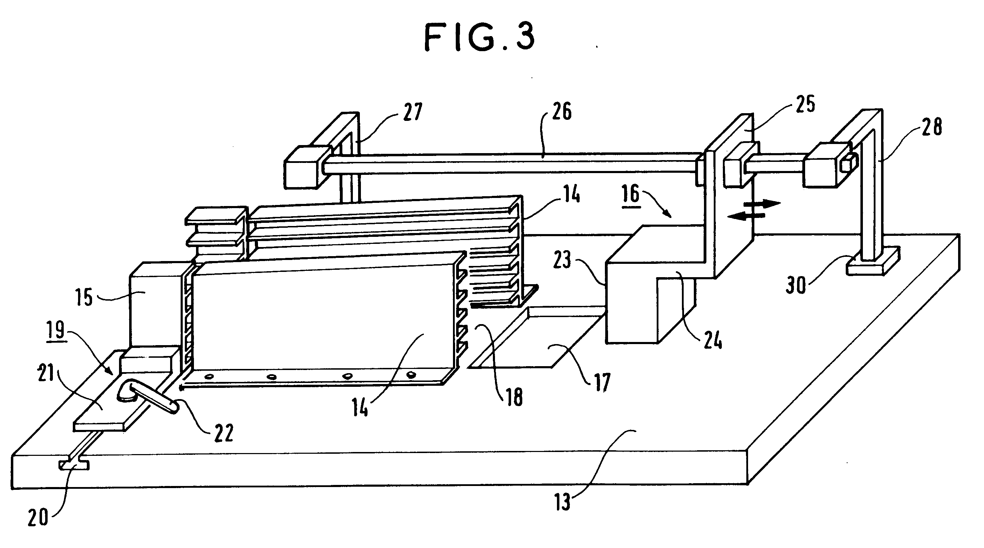

A la figure 3, on a représenté le dispositif de transfert de plaques selon l'invention. Par souci de simplification, on a représenté le dispositif dépourvu du panier et de la nacelle. Le dispositif comprend un socle 13 supportant des glissières 14 constituées par des empilements de lames en vis-à-vis, chaque série de lames étant fixées à un montant solidaire du socle 13. Les glissières sont disposées parallèlement entre elles et le couloir 18 qui les sépare constitue l'espace de circulation du poussoir 16.

Le socle 13 est pourvu d'un enfoncement 17 situé devant les glissières et dans l'axe du couloir 18. Cet enfoncement permet de loger facilement un panier de plaques pour leur transfert.

Dans le cas ou les plaques débordent largement de leur support de destination, en l'occurrence une nacelle, des mâchoires amovibles 19 sont prévues à la sortie du couloir 18 et devant l'entrée de la nacelle. Elles empêchent les plaques de basculer à leur sortie des glissières. Les mâchoires sont amovibles par glissement le long d'une rainure en T transversale 20.

Chaque mâchoire est constituée de glissières 15, dont les lames prolongent les lames des glissières 14, et fixées à une semelle 21. Chaque semelle 21 peut être immobilisée au socle 13 par une liaison du type vis-écrou : un boulon à tête carrée est disposé dans la rainure 20 et se visse, grâce à un trou percé dans la semelle, dans l'oeil de la poignée 22. Les mâchoires 19 peuvent être immobilisées ou mobiles par serrage ou desserrage de leur poignée 22.

En position fermée, les glissières des mâchoires assurent la continuité des glissières 14. Des butées placées dans la rainure 20 limitent la course des mâchoires 19 vers l'intérieur du dispositif pour assurer la continuité du couloir 18.

Les espacements des encoches du panier et de la nacelle étant différents, les lames des glissières 14, et éventuellement des glissières 15, sont inclinées de façon à assurer un transfert le moins heurté possible.

Le poussoir 16 est prévu pour pousser les plaques hors du panier lorsque celui-ci est placé dans l'enfoncement 17, à l'entrée des glissières 14. Il doit aussi pouvoir circuler dans le couloir 18 pour pousser les plaques jusqu'à la nacelle.

Le poussoir est constitué par un bloc 23 se prolongeant à sa partie supérieure arrière par une partie horizontale 24, laquelle se termine par une partie verticale 25. La partie verticale 25 est percée d'un trou carré permettant d'engager le poussoir sur la tige carrée 26. Celle-ci est maintenue au-dessus du couloir 18 et parallèlement à ce couloir par deux supports coudés 27 et 28.

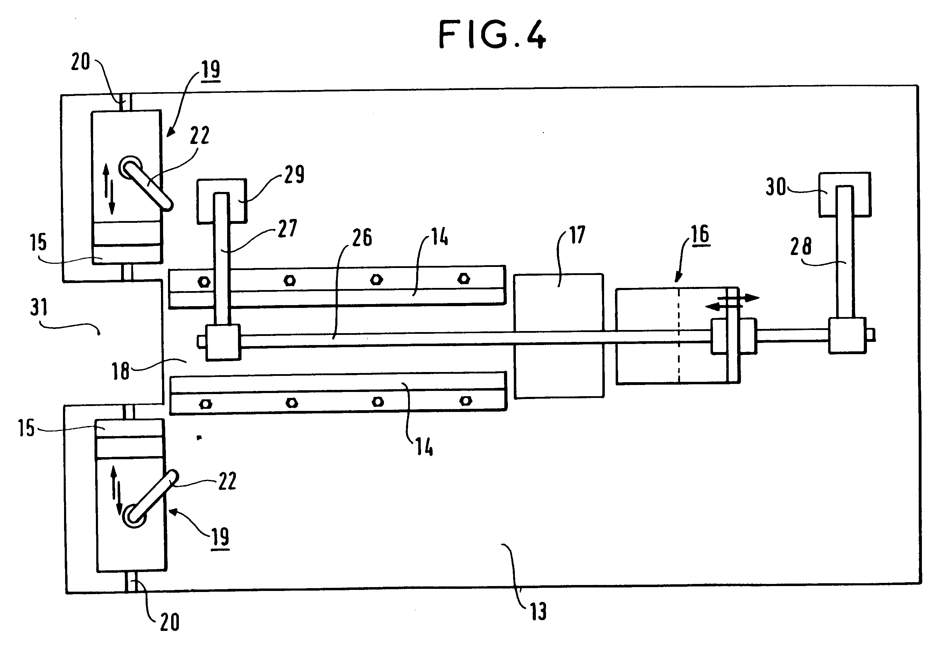

La figure 4 est une vue de dessus du dispositif selon l'invention. Elle permet de voir que les deux supports coudés 27 et 28 sont fixés au socle 13 par des embases 29 et 30. On constate aussi qu'une découpe 31 est pratiquée dans le socle, à la sortie des glissières 14. Les mâchoires 19 sont dans ce cas représentées en position ouverte.

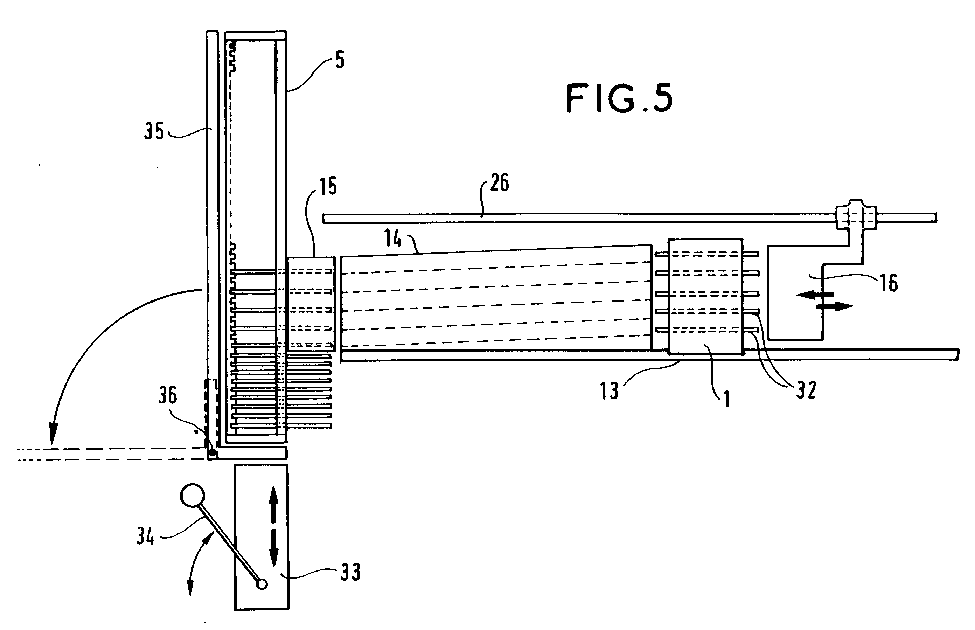

La figure 5 est une vue schématique illustrant le fonctionnement du dispositif. Le dispositif fonctionne de la façon suivante. Un panier 1 porteur de plaques 32 est disposé verticalement sur le socle 13. On transfère les plaques 32 dans les glissières à lames 14 à l'aide du poussoir 16. En poussant le poussoir vers la nacelle 5 placée sur son support 35, le bloc 23 (voir la figure 3) pénètre dans le panier 1 et chasse les plaques 32 dans les glissières 14. Le poussoir ne pouvant poursuivre sa course puisque le panier n'a pas d'ouverture sur sa face supérieure, on le tire vers l'arrière. Quand le poussoir est dégagé du panier, le panier vide est enlevé. Le poussoir est à nouveau engager pour pousser les plaques vers la nacelle 5. Les mâchoires 15 étant fermées, les plaques sont poussées jusqu'à introduction dans les encoches de la nacelle.

A ce stade, seul un emplacement sur deux de la nacelle est occupé par une plaque, les glissières 14 prolongées par les glissières des mâchoires n'ayant réduit le pas d'origine que de 4,8 mm à 4 mm par exemple.

Le dispositif comporte également un organe de déplacement vertical 33 du support de destination par l'intermédiaire de son support 35. Le déplacement de cet organe peut se faire de deux façons. Le déplacement peut être incrémental de façon à déplacer la nacelle d'un pas au moyen du levier 34. Le déplacement peut se faire par bond de 50 positions et l'organe de déplacement vertical fonctionne comme un ascenseur. Le déplacement peut être réalisé par un système à pignon et crémaillère.

Une position sur deux de la nacelle étant occupée par les plaques que l'on vient de transférer, on décale la nacelle 5 d'un pas vers le haut après avoir écarté les mâchoires, soit 2 mm dans cet exemple, à l'aide du levier 34. Puis on ferme à nouveau les mâchoires.

On retire le poussoir 16 et on introduit un nouveau panier plein. Les plaques sont transférées à la nacelle comme précédemment dans les logements intermédiaires de la nacelle laissés inoccupés.

On écarte les mâchoires qui maintiennent les plaques à proximité de la nacelle et on déplace la nacelle jusqu'aux prochaines positions libres à l'aide de l'ascenseur, soit 50 positions plus loin dans cet exemple.

On referme les mâchoires et on recommence les opérations précédentes pour le transfert des plaques jusqu'au remplissage complet de la nacelle.

Le dispositif peut être complété par un système assisté hydrauliquement afin de basculer la nacelle en position horizontale lorsqu'elle est remplie. Ceci peut être obtenu par pivotement du support 35 autour de l'axe horizontal 36.

## Revendications

1. Dispositif de transfert de plaques transversalement d'un support d'origine vers un support de destination, le support d'origine comprenant des moyens de positionnement permettant de disposer les plaques isolément les unes des autres, selon un écartement déterminé et transversalement entre deux faces ouvertes du support d'origine, le support de destination comprenant des moyens de positionnement permettant de disposer les plaques isolément les unes des autres à partir d'une face ouverte selon un écartement identique ou différent de celui du support d'origine, le dispositif comprenant des moyens de guidage des plaques disposés entre l'une des deux faces ouvertes du support d'origine et la face ouverte du support de destination, caractérisé en ce qu'il comprend en outre un poussoir mobile (16) permettant de pousser les plaques (32) hors de leur support d'origine (1) vers leur support de destination (5), le poussoir traversant dans sa course lesdits moyens de guidage composés de glissières (14) disposées de part et d'autre de l'espace de circulation du poussoir et assurant la continuité du transfert des plaques, ainsi que des moyens de déplacement vertical (33, 35) permettant de mettre le support de destination en position pour recevoir successivement le contenu de plusieurs supports d'origine.

2. Dispositif selon la revendication 1, caractérisé en ce que, les moyens de guidage amenant les plaques au support de destination selon un écartement multiple de celui des moyens de positionnement, les moyens de déplacement vertical comprennent en outre des moyens incrémentaux de déplacement (34).

3. Dispositif selon les revendications 1 ou 2, caractérisé en ce qu'il comprend des mâchoires amovibles (15) prolongeant les moyens de guidage vers le support de destination.

## Patentansprüche

1. Vorrichtung zum Transfer von Scheiben in transversaler Richtung von einem Ursprungsträger zu einem Bestimmungsträger, wobei der Ursprungsträger Positioniermittel aufweist, die die Scheiben einzeln isoliert gemäß einem vorbestimmten Abstand und in transversaler Richtung zwischen zwei offenen Seiten des Ursprungsträgers anordnen können, während der Bestimmungsträger Positioniermittel aufweist, die die Scheiben einzeln isoliert ausgehend von einer offenen Seite gemäß einem dem Abstand des Ursprungsträgers identischen oder davon unterschiedlichen Abstand anordnen, wobei die Vorrichtung Mittel zur Führung der Scheiben aufweist, die zwischen einer der beiden offenen Seiten des Ursprungsträgers und der offenen Seite des Bestimmungsträgers angeordnet sind, dadurch gekennzeichnet, daß sie außerdem einen beweglichen Drücker (16), der die Scheiben (32) aus ihrem Ursprungsträger (1) heraus zu ihrem Bestimmungsträger (5) schieben kann, wobei der Drücker auf seinem Weg die Führungsmittel durchquert, die aus Schienen (14) bestehen, die zu beiden Seiten des Bewegungsraums des Drückers angeordnet sind und die Kontinuität des Transfers der Scheiben gewährleisten, sowie Mittel (33, 35) zur senkrechten Verschiebung aufweist, die es erlauben, den Bestimmungsträger in Stellung zu bringen, um nacheinander den Inhalt mehrerer Ursprungsträger aufzunehmen.

2. Vorrichtung nach Anspruch 1, dadurch gekennzeichnet, daß die Führungsmittel die Scheiben zum Bestimmungsträger gemäß einem Abstand bringen, der ein Vielfaches des Abstands seiner Positioniermittel ist, und daß die Verschiebemittel außerdem inkrementale Verschiebemittel (34) aufweisen.

3. Vorrichtung nach Anspruch 1 oder 2, dadurch gekennzeichnet, daß sie lösbare Backen (15) aufweist, die die Führungsmittel zum Bestimmungsträger hin verlängern.

## Claims

1. Device for transferring plates transversely from a source support to a destination support, the source support including positioning means for disposing the plates isolated from each other with a particular spacing and transversely between two open sides of the source support, the destination support including positioning means for disposing the wafers isolated from each other from an open side with a spacing identical to or different from that of the source support, the device including plate guide means disposed between one of two open faces of the source support and the open face of the destination support, characterised in that it further includes a mobile pusher member (16) adapted to push the plates (32) out of their source support (1) towards their destination support (5), the pusher member moving through said guide means constituted of slideways (14) disposed on either side of the space in which the pusher member travels and ensuring continuity of transfer of the plates, and vertical displacement means (33, 35) for moving the destination support into position to receive the contents of a plurality of source supports in succession.

2. Device according to claim 1 characterised in that the guide means transfer the plates to the destination support with a spacing which is multiple of that of the positioning means and the vertical displacement means further include incremental displacement means (34).

3. Device according to claim 1 or claim 2 characterised in that it comprises removable jaws (15) extending the guide means towards the destination support.
